# EUROPEAN PATENT APPLICATION

(11) **EP 3 754 728 A1**
(43) Date of publication of application: **23.12.2020**
(21) Application number: 19748469.4
(22) Date of filing: 01.08.2019
(51) Int. Cl.: H01L 31/048, H01L 31/054, H01L 31/0468, H02S 20/26, H02S 40/22

(54) **BIPV ASSEMBLY**

(30) Priority: 06.05.2019 CN 201920641280 U
(71) Applicant: Zhongshan Ruike New Energy Co., Ltd, Torch Development Zone Zhongshan Guangdong 528437 (CN)
(72) Inventor: YU, Xiaohui, Zhongshan, Guangdong 528437 (CN); QI, Pengfei, Zhongshan, Guangdong 528437 (CN); CHEN, Shiqiang, Zhongshan, Guangdong 528437 (CN); NIU, Gaiyu, Zhongshan, Guangdong 528437 (CN); HU, Huyayi, Zhongshan, Guangdong 528437 (CN); PAN, Zhilin, Zhongshan, Guangdong 528437 (CN)
(74) Representative: Juncosa Miró, Jaime
(86) International application number: PCT/CN2019/098844
(87) International publication number: WO 2020/224068

(57) **Abstract**

Disclosed is a BIPV module, comprising a stack of a front light-transmitting plate, a power generation layer set, a bus wiring layer and a rear light-transmitting plate, wherein one of the rear light-transmitting plate and the front light-transmitting plate is provided with a pattern layer coated with color glaze at a side thereof close to the other one of the front light-transmitting plate and the rear light-transmitting plate, the bus wiring layer is attached onto the power generation layer set to form a pin, and the power generation layer set and the bus wiring layer are encapsulated between the front and rear light-transmitting plates by an encapsulation adhesive. In the present invention, by providing a color glaze pattern layer on the rear light-transmitting plate, the adhesion between the rear light-transmitting plate and the encapsulation adhesive can be increased, the weather resistance of the module can be improved, and the service life can be prolonged. Moreover, by providing the color glaze pattern layer, part of sunlight can be adsorbed and reflected, so that the room temperature is reduced in summer and the energy consumption of an air conditioner is further reduced. Furthermore, by providing the color glaze pattern layer, the influence on appearance caused by the oxidative discoloration of the encapsulation adhesive can be eliminated, so that the practicability is high.

## Description

### FIELD

The present invention belongs to the technical field of solar energy, and particularly relates to a BIPV module.

### BACKGROUND

Building Integrated Photovoltaics (BIPV) is a new concept of solar power generation. In brief, BIPV is to mount a solar photovoltaic power generation array on the outer surface of the envelop structure of the building to provide electric power. BIPV are just photovoltaic modules applied as glass curtain walls of buildings. Unlike traditional photovoltaic modules, BIPV modules require strictly defined light transmission. Therefore, generally BIPV module is a multilayer structure made of light-transmitting materials which mainly include a front light-transmitting plate, a solar power generation layer, an encapsulation adhesive layer and a rear light-transmitting plate. The solar power generation layer is encapsulated between the front and rear light-transmitting plates by an encapsulation adhesive, wherein the rear light-transmitting plate plays the role of mechanical support. During the normal operation, the encapsulation adhesive can be oxidized and the adhesion force is reduced, causing delamination and shortened product life, especially when the surface of the rear light-transmitting plate is relatively smooth. Additionally, aging effect of the encapsulation material will lead to discoloration, which will also affect the appearance.

### SUMMARY

In order to solve the above problems, according to the present invention there is provided a BIPV module which can improve the adhesion between a solar power generation layer and a rear light-transmitting plate and solve the oxidative discoloration problem of an encapsulation adhesive.

The present invention employs the following technical solutions.

A BIPV module, comprising a stack of a front light-transmitting plate, a power generation layer set, a bus wiring layer and a rear light-transmitting plate, wherein one of the rear light-transmitting plate and the front light-transmitting plate is provided with a pattern layer coated with color glaze at a side thereof close to the other one of the front light-transmitting plate and the rear light-transmitting plate, the bus wiring layer is attached onto the power generation layer set to form a pin, and the power generation layer set and the bus wiring layer are encapsulated between the front and rear light-transmitting plates by an encapsulation adhesive.

Preferably, the power generation layer set is provided with a light-transmitting structure for allowing light to pass through the power generation layer set.

Preferably, the power generation layer set is provided with a plurality of cells which are spaced apart, the cells are electrically connected by the bus wiring layer, a light-transmitting gap is formed between two adjacent cells, and the light-transmitting structure is formed by the light-transmitting gap.

Preferably, the light-transmitting structure accounts for 30% to 70% of an area of the power generation layer set.

Preferably, the power generation layer set is provided with a plurality of solar cells with a silicon wafer substrate, which are spaced apart to form the light-transmitting structure.

Preferably, each of the solar cells with the silicon wafer substrate is a monocrystalline silicon solar cell or polycrystalline silicon solar cell.

Preferably, the power generation layer set is provided with a plurality of thin-film solar cells which are etched by laser or are spaced apart to form light-transmitting gaps forming the light-transmitting structure.

Preferably, each of the thin-film solar cells is one of thin-film silicon solar cell, copper indium gallium selenide solar cell, cadmium telluride solar cell, perovskite solar cell, organic solar cell, dye-sensitized solar cell and quantum dot solar cell.

Preferably, the bus wiring layer is formed by a plurality of drainage bars and bus bars.

Preferably, both the front light-transmitting plate and the rear light-transmitting plate are made of transparent glass.

The present invention has the following beneficial effects.

In the present invention, by providing a color glaze pattern layer on the rear light-transmitting plate, the adhesion between the rear light-transmitting plate and the encapsulation adhesive can be increased, the weather resistance of the module can be improved, and the service life can be prolonged. Moreover, by providing the color glaze pattern layer, part of sunlight can be adsorbed and reflected, so that the room temperature is reduced in summer and the energy consumption of an air conditioner is further reduced. Furthermore, by providing the color glaze pattern layer, the influence on appearance caused by the oxidative discoloration of the encapsulation adhesive can be eliminated, so that the practicability is high.

### BRIEF DESCRIPTION OF THE DRAWINGS

The present invention will be further described below by embodiments with reference to the accompanying drawings, in which:
Fig. 1 is a first schematic structural diagram of the present invention;
Fig. 2 is a second schematic structural diagram of the present invention;
Fig. 3 is a third schematic structural diagram of the present invention; and
Fig.4 is a fourth schematic structural diagram of the present invention.

### DETAILED DESCRIPTION OF THE EMBODIMENTS

To make the objectives, technical solutions and advantages of the embodiments of the present invention clearer, the technical solutions in the embodiments of the present invention will be clearly and completely described below with reference to the accompanying drawings in the embodiments of the present invention. Apparently, the embodiments described herein are some but not all of the embodiments of the present invention. Generally, the modules in the embodiments of the present invention described and shown in the accompanying drawings can be arranged and designed in various different configurations. Therefore, the following detailed description of the embodiments of the present invention provided in the accompanying drawings merely represents the selected embodiments of the present invention, but is not intended to limit the claimed scope of the present invention. As those of ordinary skill in the art will understand, various features illustrated and described with reference to any one of the figures can be combined with features illustrated in one or more other figures without conflict, to produce embodiments that are not explicitly illustrated or described.

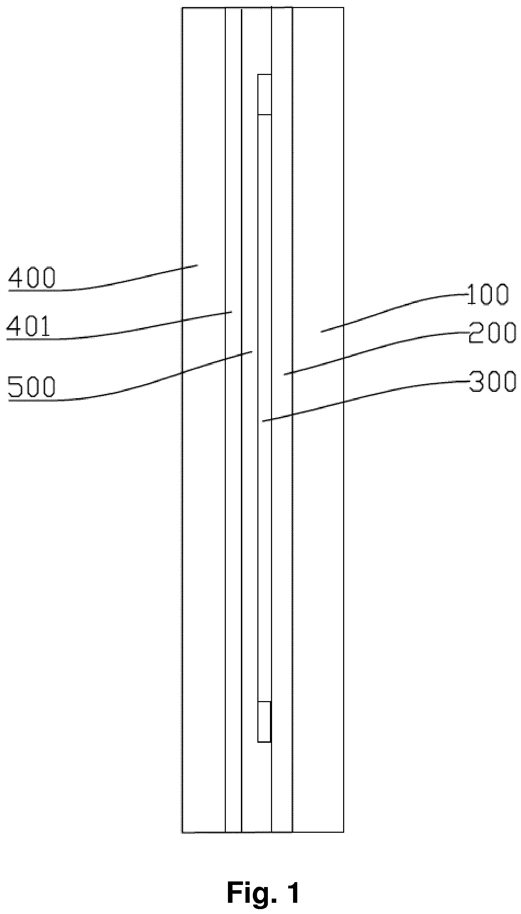

Referring to Fig. 1, a BIPV module, including a stack of a front light-transmitting plate 100, a power generation layer set 200, a bus wiring layer 300 and a rear light-transmitting plate 400, is provided according to the present invention. A pattern layer 401 coated with color glaze is provided at an end of the rear light-transmitting plate 400 close to the front light-transmitting plate 100. The bus wiring layer 300 is attached onto the power generation layer set 200 to form a pin. The power generation layer set 200 and the bus wiring layer 300 are encapsulated between the front light-transmitting plate 100 and the rear light-transmitting plate 400 by an encapsulation adhesive. An encapsulation adhesive layer 500 is formed by the encapsulation adhesive. The pattern layer 401 has a preferably rough surface, which improves its roughness in comparison to the smooth surface of the conventional rear light-transmitting plate 400.

In order to satisfy the requirements of light transmission, both the front light-transmitting plate 100 and the rear light-transmitting plate 400 are made of a transparent material, preferably transparent glass, such as tempered homogeneous glass. Moreover, a light-transmitting structure used for allowing light to pass through the power generation layer set 200 is provided on the power generation layer set 200. Since the encapsulation adhesive and the bus wiring layer 300 are light-transmittable, light can be projected onto the pattern layer 401 after successively passing through the front light-transmitting plate 100, the power generation layer set 200, the bus wiring layer 300 and the encapsulation adhesive layer 500, and then transmitted to the rear surface of the rear light-transmitting plate 400 through the pattern layer 400 to form colorful light. Therefore, the BIPV module thus arranged can satisfy the requirements of the light transmission. The power generation layer set 200 and the front light-transmitting plate 100 can be fixed by gluing or implemented by a production process. For example, the power generation layer set 200 is directly manufactured on the front light-transmitting plate 100.

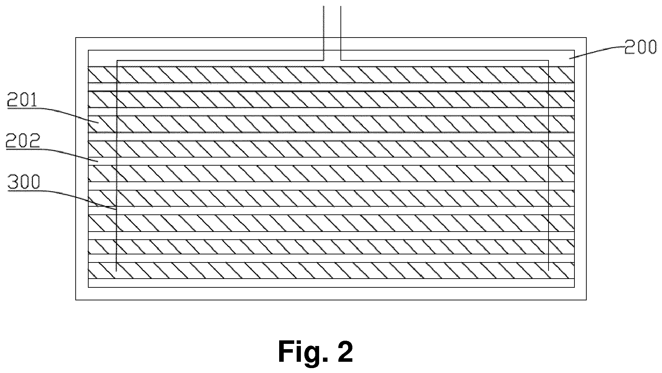

As a first preferred implementation of the light-transmitting structure, as shown in Fig. 2, preferably, the power generation layer set 200 is provided with a plurality of thin-film solar cells 201 spaced apart, the cells 201 are electrically connected by the bus wiring layer 300. Light-transmitting gaps 202, which form the light-transmitting structure, are formed between adjacent cells 201. In order to satisfy the requirements of light transmission, it is possible to manufacture the light-transmitting gaps 202 and/or reduce the width of the light-transmitting gaps 202 by laser etching.

In this implementation, each of the thin-film solar cells 201 is one of thin-film silicon solar cell, copper indium gallium selenide solar cell, cadmium telluride solar cell, perovskite solar cell, organic solar cell, dye-sensitized solar cell and quantum dot solar cell. Since such cells belong to the common knowledge, the specific structure thereof will be omitted here.

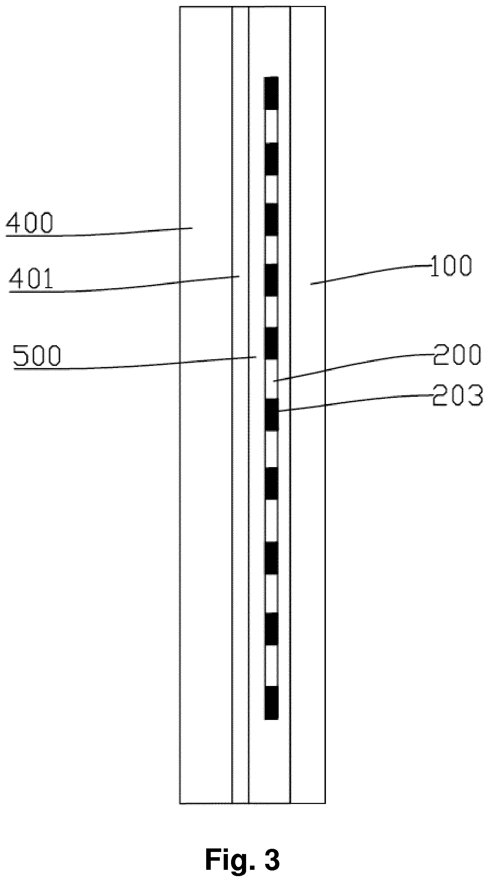

As a second preferred implementation of the light-transmitting structure, as shown in Fig. 3, preferably, the power generation layer set 200 is provided with a plurality of solar cells 203 each having a silicon wafer substrate, which are spaced apart to form the light-transmitting structure. The plurality of solar cells 203 are electrically connected by the bus wiring layer 300. In this implementation, a hollow-out light-transmitting structure can be formed by the plurality of spaced-apart solar cells 203. Further, the solar cells 203 are monocrystalline silicon solar cells or polycrystalline silicon solar cells, ensuring excellent efficiency of light energy conversion.

As a third preferred implementation of the light-transmitting structure, the power generation layer set 200 is provided with a plurality of spaced-apart cells, the cells are electrically connected by the bus wiring layer 300, a light-transmitting gap is formed between two adjacent cells, and the light-transmitting structure is formed by the light-transmitting gap.

Preferably, the light-transmitting structure accounts for 30% to 70% of the area of the power generation layer set 200, so that the requirements for the light transmission of the building can be satisfied, and the photovoltaic generation power of the BIPV module can be ensured. During the actual production process, the range can be flexibly adjusted as required, which is preferably 40% to 60%.

In the present invention, the bus wiring layer 300 is formed by a plurality of drainage bars and bus bars. The electrical connection in the power generation layer set 200 and the formation of the external pins are realized by the drainage bars and the bus bars.

In conclusion, in the present invention, by providing a color glaze pattern layer 401 on the rear light-transmitting plate 400, the adhesion between the rear light-transmitting plate 400 and the encapsulation adhesive can be increased, the weather resistance of the module can be improved, and the service life can be prolonged. Moreover, by providing the color glaze pattern layer 401, part of sunlight can be adsorbed and reflected, so that the room temperature is reduced in summer and the energy consumption of an air conditioner is further reduced. Furthermore, due to the provision of the color glaze pattern layer 401, the influence on appearance resulted from the oxidative discoloration of the encapsulation adhesive can be eliminated, so that the practicability is high. When the pattern layer 401 is directly viewed from the inside of the BIPV module, the discolored encapsulation adhesive layer 500 may be shielded, while when viewed from the outside of the BIPV module, the discolored encapsulation adhesive layer 500 will not be obviously seen either. Since both the front light-transmitting plate 100 and the rear light-transmitting plate 400 of the BIPV module can display the pattern of the pattern layer 401, the decorative effects of the inner and outer surfaces of the BIPV module can be realized while ensuring the photovoltaic power generation function, the artistry of the building structure is improved, and different pattern layers 401 may be configured according to different decorative styles. The pattern layer 401 is a color glaze coating applied on the inner surface of the rear light-transmitting plate 400. In accordance with the user's preference, color gaze coatings with different patterns can be selected to realize the diversification of products, so that the adjustment of the environmental atmosphere is realized and the people's customization requirements are satisfied. Moreover, the color glaze is stable in molecular structure and atomic structure and is difficult to discolor, and the service life of the product is prolonged.

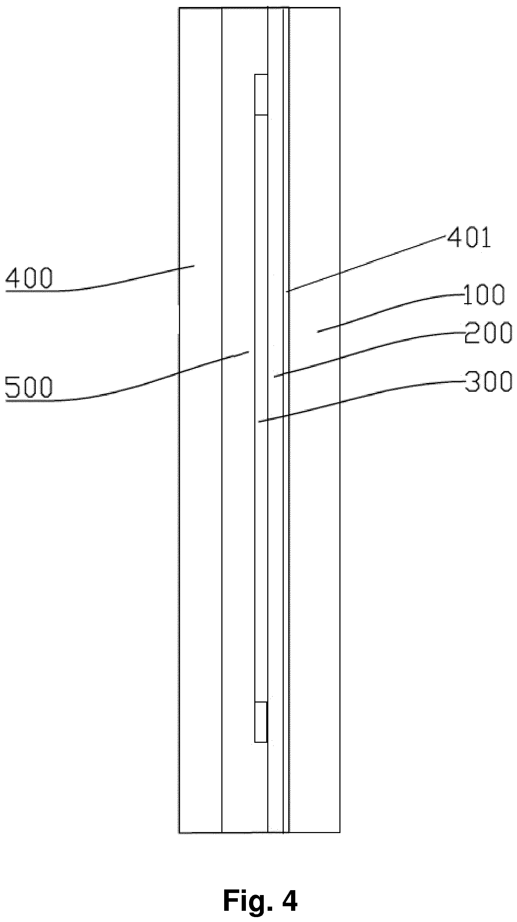

The foregoing embodiments are merely preferred solutions of the present invention, and other implementations of the present invention are also possible. For example, the power generation layer set 200 may be configured as a structure that completely covers the front light-transmitting plate 100, and the light transmission is realized by reducing the thickness of the light-transmitting plate by different technological methods. Alternatively, the pattern layer 401 coated with color glaze may be provided at a side of the front light-transmitting plate 100 close to the rear light-transmitting plate 400, as shown in Fig.4. Those skilled in the art can make equivalent modifications or substitutions without departing from the principle of the present invention, and these equivalent modifications or substitutions shall fall into the scope defined by the claims of the present application.

## Claims

1. A BIPV module, comprising a stack of a front light-transmitting plate, a power generation layer set, a bus wiring layer and a rear light-transmitting plate, wherein one of the rear light-transmitting plate and the front light-transmitting plate is provided with a pattern layer coated with color glaze at a side thereof close to the other one of the front light-transmitting plate and the rear light-transmitting plate, the bus wiring layer is attached onto the power generation layer set to form a pin, and the power generation layer set and the bus wiring layer are encapsulated between the front and rear light-transmitting plates by an encapsulation adhesive.

2. The BIPV module according to claim 1, wherein the power generation layer set is provided with a light-transmitting structure for allowing light to pass through the power generation layer set.

3. The BIPV module according to claim 2, wherein the power generation layer set is provided with a plurality of cells which are spaced apart, the cells are electrically connected by the bus wiring layer, a light-transmitting gap is formed between two adjacent cells, and the light-transmitting structure is formed by the light-transmitting gap.

4. The BIPV module according to claim 2, wherein the light-transmitting structure accounts for 30% to 70% of an area of the power generation layer set.

5. The BIPV module according to claim 2, wherein the power generation layer set is provided with a plurality of solar cells with a silicon wafer substrate, which are spaced apart to form the light-transmitting structure.

6. The BIPV module according to claim 5, wherein each of the solar cells with the silicon wafer substrate is a monocrystalline silicon solar cell or polycrystalline silicon solar cell.

7. The BIPV module according to claim 2, wherein the power generation layer set is provided with a plurality of thin-film solar cells which are etched by laser or are spaced apart to form light-transmitting gaps forming the light-transmitting structure.

8. The BIPV module according to claim 7, wherein each of the thin-film solar cells is one of thin-film silicon solar cell, copper indium gallium selenide solar cell, cadmium telluride solar cell, perovskite solar cell, organic solar cell, dye-sensitized solar cell and quantum dot solar cell.

9. The BIPV module according to claim 1, wherein the bus wiring layer is formed by a plurality of drainage bars and bus bars.

10. The BIPV module according to claim 1, wherein both the front light-transmitting plate and the rear light-transmitting plate are made of transparent glass.
